# EUROPÄISCHE PATENTSCHRIFT

(11) **EP 3 775 947 B1**
(45) Veröffentlichungstag und Bekanntmachung des Hinweises auf die Patenterteilung: **25.10.2023**
(21) Anmeldenummer: 19727856.7
(22) Anmeldetag: 15.05.2019
(51) Int. Cl.: G01R 31/34, G01R 31/12

(54) **VERFAHREN ZUR MESSUNG EINER TEILENTLADUNG IN EINEM ELEKTRISCHEN ANTRIEBSSYSTEM**
METHOD FOR MEASURING A PARTIAL DISCHARGE IN AN ELECTRIC DRIVE SYSTEM
PROCÉDÉ DE MESURE D'UNE DÉCHARGE PARTIELLE DANS UN SYSTÈME D'ENTRAÎNEMENT ÉLECTRIQUE

(30) Priorität: 08.06.2018 EP 18176746
(43) Veröffentlichungstag der Anmeldung: 17.02.2021
(73) Patentinhaber: Siemens Aktiengesellschaft, 80333 München (DE)
(72) Erfinder: JUNGIEWICZ, Artur, 13086 Berlin (DE); OBRALIC, Alija, 10437 Berlin (DE)
(74) Vertreter: Siemens Patent Attorneys
(86) Internationale Anmeldenummer: PCT/EP2019/062439
(87) Internationale Veröffentlichungsnummer: WO 2019/233716

(56) Entgegenhaltungen:
- EP-A1- 2 402 775
- EP-A1- 3 136 116
- US-A1- 2002 097 065
- US-A1- 2006 022 679

## Beschreibung

Die Erfindung betrifft ein Verfahren zur Messung einer Teilentladung in einem elektrischen Antriebssystem, welches eine elektrische rotierende Maschine und einen Umrichter umfasst.

Des Weiteren betrifft die Erfindung eine Steuereinheit mit Mitteln zur Durchführung eines derartigen Verfahrens.

Darüber hinaus betrifft die Erfindung ein Computerprogramm zur Durchführung eines derartigen Verfahrens bei Ablauf in einer Steuereinheit.

Überdies betrifft die Erfindung ein Computerprogrammprodukt mit einem Computerprogramm.

Ferner betrifft die Erfindung ein Teilentladungsmesssystem zur Durchführung eines derartigen Verfahrens.

Zudem betrifft die Erfindung ein Antriebssystem mit mindestens einer elektrischen rotierenden Maschine, mindestens einem Umrichter und mindestens einem Teilentladungsmesssystem.

Ein derartiges Verfahren wird in Antriebssystemen verwendet, deren umrichtergespeiste elektrische rotierende Maschinen, insbesondere Motoren, mit einer dreiphasigen Wechselspannung und einer Leistung von mindestens 1 MW betreibbar sind. Eine derartige elektrische rotierende Maschine weist eine Versorgungsspannung von mindestens 1kV, beispielsweise 6,6kV, auf.

Durch Inhomogenitäten im Isolationsmaterial aber auch durch Freiräume zwischen elektrischen Leitern, die nicht mit Isoliermaterial ausgefüllt sind, kann es während des Betriebes der elektrischen rotierenden Maschine zu Teilentladungen kommen, wobei eine Teilentladung einem nicht vollkommenen elektrischen Durchschlag entspricht, der sich örtlich in einer Isolierung, insbesondere an Stellen von stark inhomogenen Feldverläufen, ereignet und zu einer Beschädigung des Isolationswerkstoffs führt. Dies bedeutet, dass es durch die Teilentladungen zu einer Beschleunigung des Alterungsprozesses kommt.

Daher werden entsprechende Monitoring- und Diagnoseverfahren für Isoliersysteme eingesetzt. Neben der chemischen Isolationsdiagnose finden elektrische Diagnoseverfahren Anwendung, die insbesondere für die Isoliersysteme von Statorwicklungen eingesetzt werden. Bisher sind elektrische Teilentladungsmessungen nur offline, also im Stillstand der elektrischen rotierenden Maschine, durchführbar, da ein glattes, sinusförmiges Spannungssignal für die Messung erforderlich ist. Ein derartiges Sinussignal wird während eines Stillstandes der Anlage über eine Referenzquelle eingespeist. Offline-Messungen sind durch den Stillstand der Anlage und den damit verbundenen Produktionsausfall kostenintensiv.

Die Offenlegungsschrift DE 10 2011 080 115 A1 beschreibt eine Auskoppeleinheit zur Teilentladungsmessung an einer Hochspannungsmaschine. Die elektrischen Bauteile der Auskoppeleinheit sind integrierter Bestandteil eines Kunststoffvergussblockes, der auf der Oberseite eines Isolierstützers positioniert ist. Zu den elektrischen Bauteilen der Auskoppeleinheit gehört eine Reihenschaltung zweier Kondensatoren.

Die Offenlegungsschrift US 2002/0097065 A1 beschreibt ein Verfahren zum Bewerten von Isolationsfehlern in einem Motor mit variabler Drehzahl.

Die Offenlegungsschrift US 2006/0022679 A1 beschreibt eine Vorrichtung zur Teilentladungserkennung einer Drehstromisolation in einem Motor.

Die Offenlegungsschrift EP 2 402 775 A1 beschreibt ein Isolationsprüfungs-/Diagnoseverfahren für eine elektrische rotierende Maschine.

Die Offenlegungsschrift EP 3 136 116 A1 beschreibt eine Teilentladungsmessvorrichtung zum Messen von Teilentladungseigenschaften, die beobachtet werden, wenn eine wiederholte Stoßspannung an ein zu messendes Objekt angelegt wird.

Der Erfindung liegt die Aufgabe zugrunde, ein Verfahren zur Messung einer Teilentladung in einem elektrischen Antriebssystem anzugeben, welches während des Betriebes des elektrischen Antriebssystems durchführbar ist.

Die Aufgabe wird erfindungsgemäß durch ein Verfahren, gemäß Anspruch 1, zur Messung einer Teilentladung in einem elektrischen Antriebssystem gelöst, welches eine elektrische rotierende Maschine und einen Umrichter umfasst, wobei kontinuierlich eine Signalform eines vom Umrichter erzeugten Umrichtersignals analysiert wird, wobei, während das Umrichtersignal eine sinusförmige Signalform aufweist, ein Messsignal erfasst wird, wobei das Messsignal mit einem Referenzsignal verglichen wird, wobei, während eine Abweichung des Messsignals vom Referenzsignal einen Schwellwert überschreitet, eine Teilentladung erfasst wird.

Ferner wird die Aufgabe erfindungsgemäß durch eine Steuereinheit mit Mitteln zur Durchführung eines derartigen Verfahrens gelöst.

Darüber hinaus wird die Aufgabe erfindungsgemäß durch ein Computerprogramm zur Durchführung eines derartigen Verfahrens bei Ablauf in einer derartigen Steuereinheit gelöst.

Zudem wird die Aufgabe erfindungsgemäß durch ein Computerprogrammprodukt mit einem derartigen Computerprogramm gelöst.

Des Weiteren wird die Aufgabe erfindungsgemäß durch ein Teilentladungsmesssystem zur Durchführung eines derartigen Verfahrens gelöst, welches zumindest eine Signalanalysevorrichtung, eine Teilentladungsmessvorrichtung und eine derartige Steuereinheit aufweist.

Überdies wird die Aufgabe erfindungsgemäß durch ein Antriebssystem mit mindestens einer elektrischen rotierenden Maschine, mindestens einem Umrichter und mindestens einem derartigen Teilentladungsmesssystem gelöst.

Die in Bezug auf das Verfahren nachstehend angeführten Vorteile und bevorzugten Ausgestaltungen lassen sich sinngemäß auf die Steuereinheit, das Computerprogramm, das Computerprogrammprodukt, das Teilentladungsmesssystem und das Antriebssystem übertragen.

Der Erfindung liegt die Überlegung zugrunde, Teilentladungen während des Betriebes eines Antriebssystems zu erfassen, wobei ein derartiges Antriebssystem durch eine elektrische rotierende Maschine und einen Umrichter, welcher zum Betrieb der elektrischen rotierenden Maschine mit einem, insbesondere dreiphasigen, Wechselstromsignal vorgesehen ist, gebildet wird. Die elektrische rotierende Maschine ist mit einer Betriebsspannung von mindestens 1kV, beispielsweise mit 6,6kV, in einem Motorbetrieb oder einem Generatorbetrieb betreibbar. Eine derartige Online-Messung während des Betriebes erfordert ein glattes sinusförmiges Wechselstromsignal, was in einem Umrichterbetrieb, im Vergleich zu einem Netzbetrieb, selten zu erreichen ist. Während der Schaltvorgänge des Umrichters entstehen Spannungssprünge, die sich mit den gemessenen Teilentladungssignalen überlagern und dadurch eine Diagnose verhindern.

Um die Durchführung einer Teilentladungsmessung während des Betriebes des Antriebssystems zu ermöglichen, wird kontinuierlich eine Signalform des vom Umrichter erzeugten, insbesondere dreiphasigen, Wechselstromsignals, welches Umrichtersignal genannt wird, analysiert. Sobald das Umrichtersignal einen sinusförmigen Verlauf aufweist, wird die Teilentladungsmessung durchgeführt, indem ein Messsignal an der elektrischen rotierenden Maschine erfasst wird. Daraufhin wird das Messsignal mit einem Referenzsignal, insbesondere durch eine digitale Differenzbildung, verglichen. Eine Teilentladung wird erfasst wenn eine Abweichung des Messsignals vom Referenzsignal einen Schwellwert überschreitet.

Die Teilentladungen werden von einem Teilentladungsmesssystem erfasst, welches eine Signalanalysevorrichtung zur Analyse des Verlaufs des Umrichtersignals und eine Teilentladungsmessvorrichtung umfasst, die im Bereich der elektrischen rotierenden Maschine angeordnet ist.

Durch eine Steuereinheit wird der Verfahrensablauf gesteuert. Die Mittel zur Durchführung eines derartigen Verfahrens umfassen ein Computerprogramm und beispielweise einen Mikrocontroller oder einen anderen programmierbaren Logikbaustein. Die Steuereinheit ist beispielsweise in der Teilentladungsmessvorrichtung angeordnet.

Ein, insbesondere digitales, Triggersignal nimmt einen ersten Zustand zur Erfassung des Messsignals an, sobald das Umrichtersignal eine sinusförmige Signalform aufweist. Durch das Triggersignal wird die Erfassung des Messsignals zuverlässig und durch eine sehr geringe Verzögerung gestartet, was zu einer längeren Erfassungszeit und damit zu einer höheren Genauigkeit führt.

In einer bevorzugten Ausführungsform werden eine Anzahl und/oder eine Zeitdauer der Teilentladungen ermittelt. Derartige Informationen ermöglichen Rückschlüsse bezüglich des Alterungsprozesses des Isolationswerkstoffs. Beispielsweise durch rechtzeitige Wartung sind weitere Beschädigungen der elektrischen rotierenden Maschine und/oder lange Ausfallzeiten verhinderbar.

Erfindungsgemäß nimmt das, insbesondere digitale, Triggersignal einen zweiten Zustand zur Unterbrechung der Erfassung des Messsignals an, sobald das Umrichtersignal von der sinusförmige Signalform abweicht. Ein derartiges, insbesondere digitales, Triggersignal ist zuverlässig, wenig störanfällig und einfach umzusetzen.

In einer weiteren vorteilhaften Ausgestaltung wird ein Triggersignal in einer Signalanalysevorrichtung oder in einer IT-Infrastruktur erzeugt. Eine IT-Infrastruktur ist beispielsweise mindestens ein lokales Computersystem und/oder eine Cloud. Die IT-Infrastruktur stellt Speicherplatz, Rechenleistung und/oder Anwendungssoftware bereit. In der Cloud werden Speicherplatz, Rechenleistung und/oder Anwendungssoftware als Dienstleistung über das Internet zur Verfügung gestellt. Durch eine derartige zentrale Erzeugung des Triggersignals wird eine synchrone Signalverarbeitung gewährleistet.

Bei einer weiteren vorteilhaften Ausführungsform wird die Signalform des Umrichtersignals mittels einer FFT analysiert. Unter einer FFT ist eine Fast Fourier Transformation zu verstehen. Durch die Verwendung einer FFT lässt sich mit hoher Genauigkeit und Geschwindigkeit ermitteln, ob und wann die Signalform des Umrichtersignals sinusförmig ist.

In einer bevorzugten Ausführungsform wird das Messsignal an zumindest einer Zuleitung eines Statorwicklungssystems der elektrischen rotierenden Maschine abgegriffen. Ein derartiger Abgriff ist leicht zugänglich und insbesondere durch vorhandene Stützisolatoren kostengünstig und ohne signifikante bauliche Änderungen zu realisieren.

Bei einer weiteren vorteilhaften Ausgestaltung wird das Messsignal an zumindest einer Spule des Statorwicklungssystems der elektrischen rotierenden Maschine abgegriffen. Ein direkter Abgriff an einer Spule ermöglicht eine sehr genaue Messung.

In einer weiteren vorteilhaften Ausgestaltung wird das Messsignal über einen, insbesondere kapazitiven, Spannungsteiler abgegriffen. Insbesondere ist mindestens ein Kondensator mit einer Kapazität im pF-Bereich in einen Stützisolator integriert, wobei ein weiterer Kondensator eine Kapazität im pF-Bereich aufweist, sodass am weiteren Kondensator beispielsweise maximal 50V abfallen. Zusätzlich oder alternativ ist der Spannungsteiler mit Widerständen aufgebaut. Ein derartiger Spannungsteiler ist robust und störungsunanfällig. Daher ist das Messsignal, beispielsweise am weiteren Kondensator, einfach und zuverlässig abgreifbar.

In einer bevorzugten Ausführungsform wird das Messsignal, insbesondere mit einer Abtastrate von mindestens 10MS/s, digitalisiert. Durch eine derartig hohe Abtastrate sind auch kurze steile Signalflanken der Teilentladungen zuverlässig erfassbar.

Besonders vorteilhaft wird das digitalisierte Messsignal zumindest teilweise in der zentralen IT-Infrastruktur weiter verarbeitet. Durch eine derartige IT-Infrastruktur werden die ermittelten Daten auch bei schwierigen Umgebungsbedingungen im Bereich der elektrischen rotierenden Maschine, beispielsweise Hitze, Feuchtigkeit oder Strahlung, zuverlässig verarbeitet und bei Bedarf gespeichert.

Im Folgenden wird die Erfindung anhand der in den Figuren dargestellten Ausführungsbeispiele näher beschrieben und erläutert. Es zeigen:
- FIG 1: eine schematische Darstellung einer ersten Ausführungsform eines Antriebssystems,
- FIG 2: eine schematische Darstellung einer zweiten Ausführungsform eines Antriebssystems und
- FIG 3: eine schematische Darstellung des zeitlichen Verlaufs der Analyse des Messsignals.

Bei den im Folgenden erläuterten Ausführungsbeispielen handelt es sich um bevorzugte Ausführungsformen der Erfindung. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

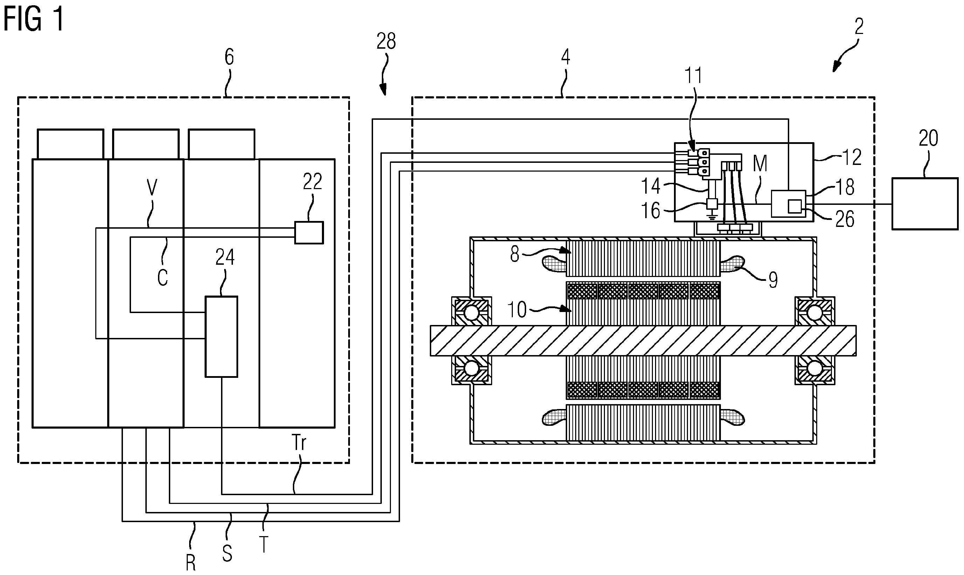

FIG 1 zeigt eine schematische Darstellung einer ersten Ausführungsform eines Antriebssystems 2, welches eine dreiphasige elektrische rotierende Maschine 4 und einen Umrichter 6 umfasst. Die elektrische rotierende Maschine 4 ist beispielsweise ein Motor und umfasst einen Stator 8 mit einem Statorwicklungssystem 9 und einen Rotor 10. Die elektrische rotierende Maschine 4 wird vom Umrichter 6, welcher als lastgeführter Stromzwischenkreisumrichter ausgeführt ist, mit einem mehrphasigen, insbesondere dreiphasigen, Leistungssignal, dem Umrichtersignal R, S, T, versorgt.

Das Umrichtersignal R, S, T wird über Zuleitungen 11 in einen Klemmkasten 12 in die elektrische rotierende Maschine 4 eingespeist. Im Klemmkasten 12 befinden sich Stützisolatoren 14, wobei beispielsweise für jede Phase des Umrichtersignals R, S, T zumindest ein Stützisolator 14 vorgesehen ist. Aus Gründen der Übersichtlichkeit ist in FIG 1 nur ein Stützisolator 14 dargestellt. Die Stützisolatoren 14 sind über eine Schiene mit dem geerdeten Gehäuse des Klemmkastens 12 verbunden und stützen die Zuleitungen 11 für das Statorwicklungssystem 9. In die Stützisolatoren ist mindestens ein Kondensator integriert. Mit einem Kondensator des Stützisolators 14 ist ein Sensor 16 verbunden, welcher beispielsweise einen weiteren Kondensator umfasst, der mit dem mindestens einen im Stützisolator 14 integrierten Kondensator einen kapazitiven Spannungsteiler bildet. Zusätzlich oder alternativ weist der Sensor 16 einen Widerstand auf. Am weiteren Kondensator wird ein Messsignal abgegriffen, das zur jeweiligen Phase des Umrichtersignals R, S, T proportional ist. Insbesondere bei einer Hochspannungsmaschine, welche mit einer Betriebsspannung von mindestens 1kV betreibbar ist, lässt sich das Messsignal M über ein Netzwerk, welches mindestens einen Kondensator aufweist, im Wesentlichen verlustfrei und mit einem deutlich geringeren Pegel abgreifen, was die weitere Signalverarbeitung erleichtert. Zusätzlich oder alternativ wird ein Messsignal M an einer Spule des Statorwicklungssystems 9 abgegriffen.

Das digitale Messsignal M wird zur weiteren Verarbeitung an eine Teilentladungsmessvorrichtung 18 geleitet und digitalisiert. Alternativ umfasst der Sensor 16 zusätzlich eine Wandlereinheit, welche das am weiteren Kondensator abfallende analoge Spannungssignal in ein digitales Messsignal M umwandelt. Um auch sehr steile Signalflanken der Teilentladungen Te erfassen zu können, wird der Wandler mit einer hohen Abtastrate, beispielsweise im Megasample-Bereich oder im Gigasample-Bereich, betrieben.

Anschließend wird das digitalisierte Messsignal M mit einem Referenzsignal Rs verglichen, welches beispielsweise von der Teilentladungsmessvorrichtung 18 aus dem Umrichtersignal R, S, T erzeugt wird. Ein Vergleich des Messsignals M mit dem Referenzsignal Rs erfolgt beispielsweise digital mittels Differenzbildung. Überschreitet eine Abweichung des Messsignals M vom Referenzsignal Rs einen Schwellwert Sw, wird eine Teilentladung Te erfasst. Es werden eine Anzahl und/oder eine Zeitdauer der Teilentladungen Te ermittelt. Die ermittelten Daten zu den Teilentladungen Te werden digitalisiert und, zumindest teilweise, an eine zentrale IT-Infrastruktur 20 gesendet. Eine IT-Infrastruktur 20 ist beispielsweise mindestens ein lokales Computersystem und/oder eine Cloud. Die IT-Infrastruktur 20 stellt Speicherplatz, Rechenleistung und/oder Anwendungssoftware bereit. In der Cloud werden Speicherplatz, Rechenleistung und/oder Anwendungssoftware als Dienstleistung über das Internet zur Verfügung gestellt. Die digitale Datenübertragung an die IT-Infrastruktur 20 findet drahtlos, drahtgebunden oder optisch statt. Beispielsweise werden die Daten über Bluetooth oder WLAN übertragen.

Teilentladungen Te sind nur bei einem sinusförmigen Verlauf des vom Umrichter generierten Umrichtersignals R, S, T durch eine Online-Messung also während des Betriebes der elektrischen rotierenden Maschine 4, störungsfrei erfassbar, wobei das Umrichtersignal R, S, T des Umrichters 6, welcher als lastgeführter Stromzwischenkreisumrichters ausgeführt ist, teilweise einen sinusförmigen Verlauf aufweist.

Über eine Schnittstelle 22 am Umrichter 6 wird ein, insbesondere dreiphasiges, analoges Spannungssignal V und ein, insbesondere dreiphasiges, analoges Stromsignal C an eine Signalanalysevorrichtung 24 übertragen, wobei das analoge Spannungssignal V und das analoge Stromsignal C bevorzugt am Ausgang des Umrichters 6 abgegriffen werden und den Verlauf des dreiphasigen Umrichtersignals R, S, T wiedergeben. Von der Signalanalysevorrichtung 24 werden hochaufgelöste Messdaten bereitgestellt, mit Hilfe derer die Signalform des Umrichtersignals R, S, T, insbesondere mittels einer FFT, analysiert wird. Aus der Signalform des Umrichtersignals R, S, T wird ein, insbesondere digitales, Triggersignal Tr erzeugt. Das Triggersignal Tr nimmt einen ersten Zustand, beispielsweise eine logische 1, an, sobald das Umrichtersignal R, S, T einen glatten sinusförmigen Verlauf aufweist. Ist der Verlauf des Umrichtersignals R, S, T nicht sinusförmig, weist das Triggersignal Tr einen zweiten Zustand, beispielsweise eine logische 0, auf.

Durch das Triggersignal Tr der Signalanalysevorrichtung 24 wird die Messung durch die Teilentladungsmessvorrichtung 18 nur bei einem entsprechend sinusförmigen Verlauf des Umrichtersignals R, S, T aktiviert, ansonsten bleibt diese deaktiviert, da keine störungsfreie Messung möglich ist. Es wird also eine digitale Kopplung zwischen den Schaltvorgängen des Umrichters 6 und der Ansteuerung der Teilentladungsmessvorrichtung 18 realisiert, durch die eine Online-Messung von Teilentladungen Te an der elektrischen rotierenden Maschine 4, welche von einem lastgeführten Stromzwischenkreisumrichter angetrieben wird, ermöglicht wird. Durch eine Steuereinheit 26, welche der Teilentladungsmessvorrichtung 18 zugewiesen ist, wird der Verfahrensablauf gesteuert. Die Steuereinheit 26 bildet zusammen mit der Signalanalysevorrichtung 24 und der Teilentladungsmessvorrichtung 18 ein Teilentladungsmesssystem 28.

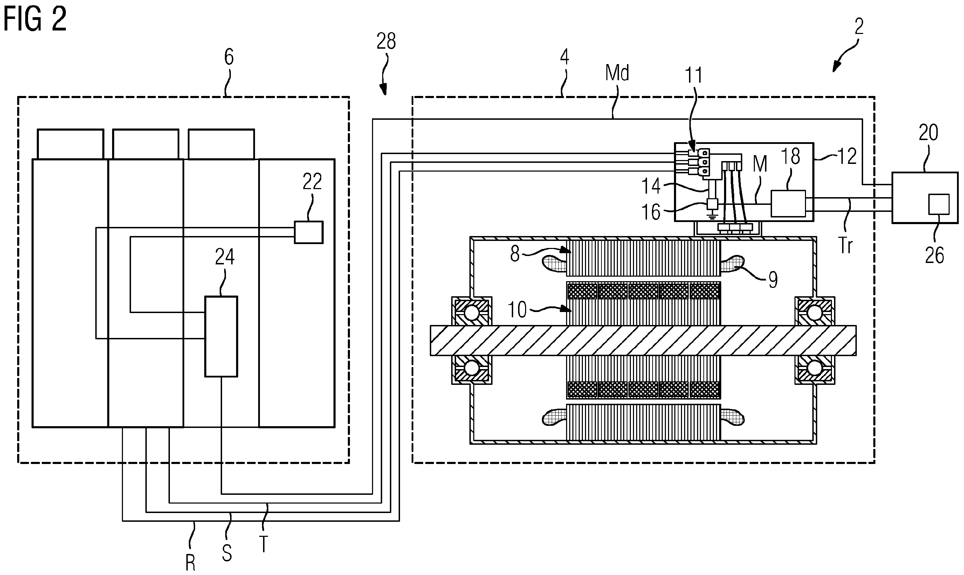

FIG 2 zeigt eine schematische Darstellung einer zweiten Ausführungsform eines Antriebssystems 2. Die von der Signalanalysevorrichtung 24 bereitgestellten hochaufgelösten Messdaten werden als Messdatensignal Md an die IT-Infrastruktur 20 gesendet. Dort wird mit Hilfe der hochaufgelösten Messdaten die Signalform des Umrichtersignals R, S, T, insbesondere mittels einer FFT, analysiert. Aus der Signalform des Umrichtersignals R, S, T wird das, insbesondere digitale, Triggersignal Tr erzeugt, welches an die Teilentladungsmessvorrichtung 18 gesendet wird.

Durch die Steuereinheit 26, welche der IT-Infrastruktur 20 zugewiesen ist, wird der Verfahrensablauf gesteuert. Das Messsignal M und das Referenzsignal Rs werden nach der Digitalisierung in der Teilentladungsmessvorrichtung 18 an die zentrale IT-Infrastruktur 20 gesendet und dort weiter verarbeitet. Die weitere Ausführung des Antriebssystems 2 in FIG 2 entspricht der in FIG 1.

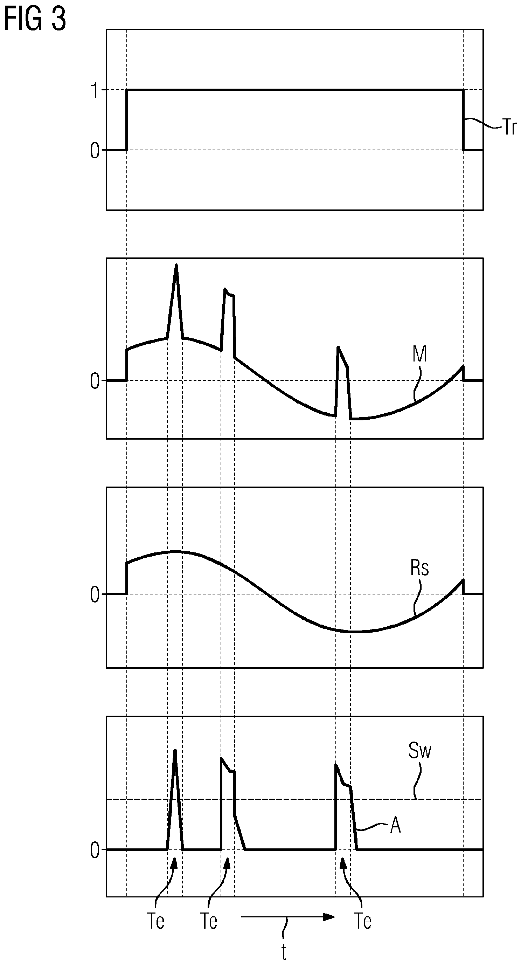

FIG 3 zeigt eine schematische Darstellung des zeitlichen Verlaufs der Analyse des Messsignals M. Nimmt das Triggersignal Tr bei einem sinusförmigen Verlauf des vom Umrichter generierten Umrichtersignals R, S, T eine logische 1 an, wird die Erfassung des Messsignals M gestartet. Das Referenzsignal Rs wird vom Messsignal M subtrahiert, wobei ein Abweichungssignal A des Messsignals M vom Referenzssignal erzeugt wird. Überschreitet das Abweichungssignal A einen Schwellwert Sw, wird eine Teilentladung Te erfasst. Daraufhin werden eine Anzahl und/oder eine Zeitdauer der Teilentladungen Te ermittelt.

Zusammenfassend betrifft die Erfindung ein Verfahren zur Messung einer Teilentladung Te in einem elektrischen Antriebssystem 2, welches eine elektrische rotierenden Maschine 4 und einen Umrichter 6 umfasst. Damit das Verfahren während des Betriebes des elektrischen Antriebssystems 2 durchführbar ist, wird vorgeschlagen, dass kontinuierlich eine Signalform eines vom Umrichter 6 erzeugten Umrichtersignals R, S, T analysiert wird, wobei, während das Umrichtersignal R, S, T eine sinusförmige Signalform aufweist, ein Messsignal M erfasst wird, wobei das Messsignal M mit einem Referenzsignal Rs verglichen wird, wobei, während eine Abweichung A des Messsignals M vom Referenzsignal Rs einen Schwellwert Sw überschreitet, eine Teilentladung Te erfasst wird.

## Patentansprüche

1. Verfahren zur Messung einer Teilentladung (Te) in einem elektrischen Antriebssystem (2),
welches eine elektrische rotierende Maschine (4) und einen Umrichter (6) umfasst,
wobei kontinuierlich eine Signalform eines vom Umrichter (6) erzeugten Umrichtersignals (R,S,T) analysiert wird, wobei, während das Umrichtersignal (R,S,T) eine sinusförmige Signalform aufweist, ein Messsignal (M) erfasst wird,
wobei das Messsignal (M) mit einem Referenzsignal (Rs) verglichen wird,
wobei, während eine Abweichung des Messsignals (M) vom Referenzsignal (Rs) einen Schwellwert (Sw) überschreitet, eine Teilentladung (Te) erfasst wird,
wobei, sobald das Umrichtersignal (R,S,T) eine sinusförmige Signalform aufweist, ein, insbesondere digitales, Triggersignal (Tr) einen ersten Zustand zur Erfassung des Messsignals (M) annimmt,
**dadurch gekennzeichnet, dass**,
sobald das Umrichtersignal (R,S,T) von der sinusförmigen Signalform abweicht, das, insbesondere digitale, Triggersignal (Tr) einen zweiten Zustand zur Unterbrechung der Erfassung des Messsignals (M) annimmt.

2. Verfahren nach Anspruch 1, wobei eine Anzahl und/oder eine Zeitdauer von Teilentladungen (Te) ermittelt werden.

3. Verfahren nach Anspruch 1 oder 2, wobei das Triggersignal (Tr) in einer Signalanalysevorrichtung (24) oder in einer IT-Infrastruktur (20) erzeugt wird.

4. Verfahren nach einem der vorherigen Ansprüche, wobei die Signalform des Umrichtersignals (R,S,T) mittels einer FFT analysiert wird.

5. Verfahren nach einem der vorherigen Ansprüche, wobei das Messsignal (M) an zumindest einer Zuleitung (11) eines Statorwicklungssystems (9) der elektrischen rotierenden Maschine (4) abgegriffen wird.

6. Verfahren nach einem der Ansprüche 1-4, wobei das Messsignal (M) an zumindest einer Spule eines Statorwicklungssystems (9) der elektrischen rotierenden Maschine (4) abgegriffen wird.

7. Verfahren nach einem der vorherigen Ansprüche, wobei das Messsignal (M) über einen, insbesondere kapazitiven, Spannungsteiler abgegriffen wird.

8. Verfahren nach einem der vorherigen Ansprüche, wobei das Messsignal (M), insbesondere mit einer Abtastrate von mindestens 10MS/s, digitalisiert wird.

9. Verfahren nach Anspruch 7, wobei das digitalisierte Messsignal (M) zumindest teilweise in einer zentralen IT-Infrastruktur (20) weiterverarbeitet wird.

10. Steuereinheit (26) mit Mitteln zur Durchführung eines Verfahrens nach einem der Ansprüche 1 bis 9.

11. Computerprogramm zur Durchführung eines Verfahrens nach einem der Ansprüche 1 bis 9 bei Ablauf in einer Steuereinheit (26) nach Anspruch 10.

12. Computerprogrammprodukt mit einem Computerprogramm nach Anspruch 11.

13. Teilentladungsmesssystem (28) zur Durchführung eines Verfahrens nach einem der Ansprüche 1 bis 9, welches zumindest eine Signalanalysevorrichtung (24), eine Teilentladungsmessvorrichtung (18) und eine Steuereinheit (26) nach Anspruch 10 aufweist.

14. Antriebssystem (2) mit mindestens einer elektrischen rotierenden Maschine (4), mindestens einem Umrichter (6) und mindestens einem Teilentladungsmesssystem (28) nach Anspruch 13.

15. Antriebssystem (2) nach Anspruch 14, wobei der Umrichter (6) als Stromzwischenkreisumrichter ausgeführt ist.

## Claims

1. Method for measuring a partial discharge (Te) in an electric drive system (2),
which comprises an electric rotating machine (4) and a converter (6),
wherein a signal shape of a converter signal (R, S, T) generated by the converter (6) is analysed continuously,
wherein a measuring signal (M) is detected while the converter signal (R, S, T) has a sinusoidal signal shape,
wherein the measuring signal (M) is compared with a reference signal (Rs),
wherein a partial discharge (Te) is detected while a deviation of the measuring signal (M) from the reference signal (Rs) exceeds a threshold value (Sw),
wherein a, in particular digital, trigger signal (Tr) assumes a first state for detecting the measuring signal (M) as soon as the converter signal (R, S, T) has a sinusoidal signal shape,
**characterised in that**
as soon as the converter signal (R, S, T) deviates from the sinusoidal signal shape, the, in particular digital, trigger signal (Tr) assumes a second state for the purpose of interrupting the detection of the measuring signal (M).

2. Method according to claim 1, wherein a number and/or a duration of partial discharges (Te) is/are determined.

3. Method according to claim 1 or 2, wherein the trigger signal (Tr) is generated in a signal analysis device (24) or in an IT infrastructure (20).

4. Method according to one of the preceding claims, wherein the signal shape of the converter signal (R, S, T) is analysed by means of an FFT.

5. Method according to one of the preceding claims, wherein the measuring signal (M) is tapped at at least one supply line (11) of a stator winding system (9) of the electric rotating machine (4).

6. Method according to one of claims 1 - 4, wherein the measuring signal (M) is tapped at at least one coil of the stator winding system (9) of the electric rotating machine (4) .

7. Method according to one of the preceding claims, wherein the measuring signal (M) is tapped by way of a, in particular capacitive, voltage divider.

8. Method according to one of the preceding claims, wherein the measuring signal (M), in particular with a scanning rate of at least 10 MS/s, is digitised.

9. Method according to claim 7, wherein the digitised measuring signal (M) is further processed at least partially in a central IT infrastructure (20).

10. Control unit (21) with means for carrying out a method according to one of claims 1 to 9.

11. Computer program for carrying out a method according to one of claims 1 - 9 when run in a control unit (26) according to claim 10.

12. Computer program product comprising a computer program according to claim 11.

13. Partial discharge measuring system (28) for carrying out a method according to one of claims 1 to 9, which has at least one signal analysis device (24), a partial discharge measuring device (18) and a control unit (26) according to claim 10.

14. Drive system (2) with at least one electric rotating machine (4), at least one converter (6) and at least one partial discharge measuring system (28) according to claim 13.

15. Drive system (2) according to claim 14, wherein the converter (6) is embodied as a current indirect converter.

## Revendications

1. Procédé de mesure d'une décharge (Te) partielle dans un système (2) électrique d'entraînement,
qui comprend une machine (4) électrique tournante et un onduleur (6),
dans lequel on analyse en continu une forme d'un signal (R, S, T) d'onduleur produite par l'onduleur (6),
dans lequel pendant que le signal (R, S, T) d'onduleur a une forme de signal sinusoïdale, on détecte un signal (M) de mesure, dans lequel on compare le signal (M) de mesure à un signal (Rs) de référence,
dans lequel, pendant qu'un écart du signal (M) de mesure au signal (Rs) de référence dépasse une valeur (Sw) de seuil, on détecte une décharge (Te) partielle,
dans lequel, dès que le signal (R, S, T) d'onduleur a une forme de signal sinusoïdal, un signal (Tr) de déclenchement, en particulier numérique, prend un premier état pour la détection du signal (M) de mesure,
**caractérisé en ce que**
dès que le signal (R, S, T) d'onduleur s'écarte de la forme de signal sinusoïdal, le signal (Tr) de déclenchement, en particulier numérique, prend un deuxième état pour l'interruption de la détection du signal (M) de mesure.

2. Procédé suivant la revendication 1, dans lequel on détermine un nombre et/ou une durée de décharges (Te) partielles.

3. Procédé suivant la revendication 1 ou 2, dans lequel on produit le signal (Tr) de déclenchement dans un dispositif (24) d'analyse du signal ou dans une infrastructure (20) IT.

4. Procédé suivant l'une des revendications précédentes, dans lequel on analyse la forme du signal (R, S, T) d'onduleur au moyen d'un FFT.

5. Procédé suivant l'une des revendications précédentes, dans lequel on prélève le signal (M) de mesure sur au moins une ligne (11) d'alimentation d'un système (9) d'enroulement statorique de la machine (4) électrique tournante.

6. Procédé suivant l'une des revendications 1 à 4, dans lequel on prélève le signal (M) de mesure sur au moins une bobine d'un système (9) d'enroulement statorique de la machine (4) électrique tournante.

7. Procédé suivant l'une des revendications précédentes, dans lequel on prélève le signal (M) de mesure par un diviseur de tension, en particulier capacitif.

8. Procédé suivant l'une des revendications précédentes, dans lequel on numérise le signal (M) de mesure, en particulier à un taux d'échantillonnage d'au moins 10MS/s.

9. Procédé suivant la revendication 7, dans lequel on retraite le signal (M) de mesure numérisé au moins en partie dans une infrastructure (20) IT centrale.

10. Unité (26) de commande comprenant des moyens pour effectuer un procédé suivant l'une des revendications 1 à 9.

11. Programme d'ordinateur pour effectuer un procédé suivant l'une des revendications 1 à 9 lorsqu'il se déroule dans une unité (26) de commande suivant la revendication 10.

12. Produit de programme d'ordinateur comprenant un programme d'ordinateur suivant la revendication 11.

13. Système (28) de mesure de décharge partielle pour effectuer un procédé suivant l'une des revendications 1 à 9, qui comporte au moins un dispositif (24) d'analyse du signal, un dispositif (18) de mesure de décharge partielle et une unité (26) de commande suivant la revendication 10.

14. Système (2) d'entraînement comprenant au moins une machine (4) électrique tournante, au moins un onduleur (6) et au moins un système (28) de mesure de charge partielle suivant la revendication 13.

15. Système (2) d'entraînement suivant la revendication 14, dans lequel l'onduleur (6) est réalisé sous la forme d'un onduleur à circuit intermédiaire.
